# FASCICULE DE BREVET EUROPEEN

(11) **EP 2 625 711 B1**
(45) Date de publication et mention de la délivrance du brevet: **25.03.2015**
(21) Numéro de dépôt: 11779802.5
(22) Date de dépôt: 05.10.2011
(51) Int. Cl.: H01L 21/768, H01L 23/522, H01L 23/532

(54) **PROCÉDÉ DE FABRICATION D'UN CIRCUIT**
VERFAHREN ZUR HERSTELLUNG EINES SCHALTKREISES
METHOD FOR MANUFACTURING A CIRCUIT

(30) Priorité: 05.10.2010 FR 1058076
(43) Date de publication de la demande: 14.08.2013
(73) Titulaire: Centre National de la Recherche Scientifique (CNRS), 75016 Paris (FR)
(72) Inventeur: GHANNAM, Ayad, F-31400 Toulouse (FR); BOURRIER, David, F-31400 Toulouse (FR); DILHAN, Monique, F-31830 Plaisance (FR); VIALLON, Christophe, F-31400 Toulouse (FR); PARRA, Thierry, F-31400 Toulouse (FR)
(74) Mandataire: Blot, Philippe Robert Emile
(86) Numéro de dépôt international: PCT/FR2011/052325
(87) Numéro de publication internationale: WO 2012/045981

(56) Documents cités:
- EP-A2- 1 737 037
- US-A- 5 037 782
- US-A1- 2006 042 952
- US-A1- 2006 063 371
- US-A1- 2008 054 457
- US-A1- 2009 026 610
- US-A1- 2009 072 379
- US-A1- 2009 206 486

## Description

La présente invention concerne un procédé de fabrication d'un circuit intégré comme divulgué dans la revendication 1.

### Domaine de l'invention

Le développement actuel des télécommunications mobiles s'accompagne d'une demande sans cesse croissante en nouvelles technologies de plus en plus performantes, faibles coûts et fiables pour la réalisation de circuits électroniques hautes fréquences et miniaturisés. Dans ce contexte, la supériorité des technologies monolithiques apparaît indéniable si on les compare aux technologies hybrides qui consistent à assembler par soudage des composants électroniques discrets.

Ces technologies sont mises en oeuvre par un fondeur, ce qui ne permet généralement pas d'accéder au procédé technologique. Dans ce cas, il est alors possible de former les composants électroniques passifs ou les lignes d'interconnexion au dessus du substrat contenant les composants actifs, à l'aide d'un procédé complémentaire compatible. Ce type d'intégration est appelé intégration « above-IC ».

Pour certaines applications (comme par exemple l'amplification de puissance RF et micro-ondes, le filtrage passif RF, le report et les interconnexions de puces, l'intégration d'antennes sur puce ...) il est nécessaire de disposer d'un procédé permettant de réaliser des composants passifs et des interconnexions présentant de bonnes performances électriques et insensibles à la qualité diélectrique du substrat. Ce point est particulièrement critique dans le cas des applications sur silicium car, les filières technologiques s'accompagnant généralement de substrats peu résistifs, les composants passifs présentent des pertes importantes. En particulier, dans le cas où les composants passifs formés sur le substrat sont des inductances, la faible résistivité du substrat conduit à un mauvais facteur de qualité pour ces inductances. De même, pour augmenter encore le facteur de qualité des composants, ou diminuer leur niveau de pertes, il est nécessaire d'implémenter des niveaux métalliques de forte épaisseur.

### Etat de la technique

Afin de limiter les interactions entre le substrat et les composants électroniques passifs pour lesquels on souhaite une grande qualité, il est possible d'écranter le substrat à l'aide d'un plan métallique et de former sur cet écran des couches épaisses de matériau isolant sur lesquelles sont réalisés ces composants passifs. Pour connecter les composants, par exemple actifs, éventuellement intégrés en surface du substrat, et les composants passifs formés au dessus de ce substrat sur la couche épaisse du matériau isolant, il est nécessaire de réaliser des ouvertures d'interconnexion métallisées traversant entièrement la couche diélectrique épaisse. Comme mentionné précédemment, il convient aussi que les composants soient formés à partir de niveaux métalliques d'épaisseur suffisante.

A cet effet, on peut utiliser un procédé consistant à successivement :
a- déposer une couche d'accrochage, formant une base de croissance électrolytique sur la surface supérieure du substrat ;
b- déposer sur cette couche d'accrochage une couche épaisse de résine dans laquelle des ouvertures sont réalisées par photolithographie uniquement dans les zones dans lesquelles on souhaite former la première partie de la structure électrique. Cette première partie de la structure formera des éléments d'interconnexion réalisant l'interconnexion électrique entre les composants intégrés en surface du substrat semiconducteur et les composants qui seront formés en surface du matériau isolant épais ;
c- faire croître dans les ouvertures réalisées dans la résine le ou les éléments d'interconnexion par dépôt électrolytique d'un matériau conducteur, à partir de la couche d'accrochage ;
d- retirer la couche de résine ;
e- graver la couche d'accrochage dans les zones dans lesquelles elle n'est pas recouverte par la première partie de la structure électrique ;
f- déposer autour de la première partie de la structure électrique une couche diélectrique par enduction centrifuge ;
g- polir la surface supérieure de la couche diélectrique ;

Le polissage de la surface supérieure de la couche diélectrique est nécessaire car la présence de la première partie de la structure électrique au sein de la couche diélectrique engendre des irrégularités d'épaisseur de cette couche lors de son enduction centrifuge.

A l'issue de cette étape, on a formé sur le substrat une couche diélectrique et les éléments d'interconnexion au travers de cette couche diélectrique.
h- On forme ensuite un élément de structure s'étendant sur la couche diélectrique et formant un niveau d'interconnexion. A cet effet, on dépose successivement sur la couche diélectrique une nouvelle couche métallique d'accrochage puis une couche de résine structurée sur cette couche d'accrochage, avant de procéder au dépôt électrolytique du niveau d'interconnexion ;
i- on dissout la résine ;
j- on grave la couche d'accrochage.

Pour chaque niveau d'interconnexions supplémentaire, il est généralement nécessaire de refaire les étapes a- jusqu'à j-, une variante consistant à ne pas réaliser l'étape j- et à reprendre depuis l'étape b-.

Ainsi, un grand nombre d'étapes technologiques est nécessaire pour obtenir une structure électrique passive, comprenant un ou plusieurs niveaux d'interconnexions, lorsque sur le circuit intégré sont déposées une ou plusieurs couches diélectriques isolantes d'épaisseurs importantes.

US2008054457A1 divulgue un procédé de fabrication d'un circuit intégré avec déposition d'une structure électrique par croissance électrolytique sur un ensemble comprenant une première surface et une deuxième surface et un flanc s'étendant entre la première surface et la deuxième surface. Une base de croissance électrolytique en forme d'un revêtement de métallisation est déposée en même temps sur les surfaces et le flanc de l'ensemble avant la croissance électrolytique.

Le but de l'invention est de proposer un procédé de fabrication semblable au procédé décrit précédemment mais dont le nombre d'étapes technologiques est fortement réduit.

### Exposé de l'invention

A cet effet, l'invention a pour objet un procédé de fabrication d'un circuit intégré du type précité, dans lequel le flanc présente une hauteur supérieure à 10µm, et la structure électrique est formée par dépôt du matériau conducteur de l'électricité en déposant simultanément l'élément de structure sur la surface supérieure de la couche diélectrique et l'élément d'interconnexion sur le flanc.

Le procédé selon l'invention peut comprendre l'une ou plusieurs des caractéristiques suivantes, prise(s) isolément ou selon toute(s) combinaison(s) techniquement possible(s) :
- la ou chaque couche diélectrique est en matériau polymère ;
- le flanc de la couche diélectrique est en contre dépouille par rapport à la surface supérieure du substrat ou normal à la surface supérieure du substrat ;
- l'étape de formation de la structure électrique comprend successivement :
   - le dépôt d'un premier revêtement de métallisation sur la couche inférieure sous-jacente et sur la surface supérieure de la ou chaque couche diélectrique ;
   - le dépôt d'un deuxième revêtement de métallisation sur le flanc de la ou chaque couche diélectrique; et
   - le dépôt de la structure électrique par croissance électrolytique simultanément sur le premier revêtement de métallisation et le deuxième revêtement de métallisation.
- le dépôt du deuxième revêtement de métallisation est réalisé par traitement chimique du flanc de la couche diélectrique.
- l'étape de formation de la structure électrique comprend, après les dépôts du premier et deuxième revêtement de métallisation, le dépôt d'une couche de résine laissant découvertes les régions du premier revêtement de métallisation destinées à être recouvertes par la structure électrique lors de l'étape de dépôt électrolytique, et le retrait de la couche de résine après le dépôt électrolytique.
- au moins une couche diélectrique est munie d'une ouverture d'interconnexion traversante délimitée par le flanc ;
- on forme sur la surface sous-jacente plusieurs couches diélectriques superposées définissant une structure diélectrique en gradin, chaque couche diélectrique présentant une surface supérieure et un flanc s'étendant entre sa surface supérieure et la surface supérieure d'une couche diélectrique sous-jacente ou la surface sous-jacente, au moins l'un des flancs présentant une hauteur supérieure à 10µm, et on forme la structure électrique en déposant simultanément un élément de structure s'étendant sur la surface supérieure de chaque couche diélectrique et un élément d'interconnexion s'étendant le long du flanc de chaque couche diélectrique à partir de l'élément de structure s'étendant sur la surface supérieure de cette couche diélectrique jusqu'à la surface supérieure de la couche diélectrique sous-jacente ou jusqu'à la surface sous-jacente.
- le flanc de chaque couche diélectrique présente une épaisseur supérieure à 10µm.
- chaque couche diélectrique est en matériau polymère.
- la structure électrique est formée par dépôt électrolytique.

L'invention permet la mise en oeuvre d'un procédé « above IC » faibles températures basé sur le dépôt d'un diélectrique polymère épais (par ex. jusqu'à 140 µm) dans lequel sont réalisés des trous métallisés pour les connexions électriques avec la puce active. Les métallisations sont réalisées en surface de ce diélectrique par croissance électrolytique (jusqu'à 35 µm d'épaisseur). Les avantages du procédé résident notamment dans la structuration du polymère, pour limiter les contraintes mécaniques subies par le substrat hôte, ainsi que dans la croissance du métal en une seule étape, pour le remplissage des trous métallisés et pour la réalisation des interconnexions et des inductances en surface du polymère. En effet, ce procédé rend possible la fabrication, en une seule étape, de lignes métalliques continues capables d'enjamber des flancs de diélectrique verticaux et de hauteurs importantes. Avec ce même procédé, une ligne de connexion peut être intégrée sur plusieurs niveaux diélectriques épais en une étape unique de croissance du métal. Enfin, ce procédé peut être utilisé pour intégrer plusieurs niveaux d'interconnexions. Dans tous les cas, la puce finale est plus robuste sur le plan mécanique, et, en supprimant un grand nombre d'interfaces entre niveaux métalliques, les performances électriques des structures sont améliorées.

L'invention concerne également un circuit intégré obtenu selon un procédé de l'invention.

Ainsi, elle concerne de manière générale un circuit intégré comprenant un substrat présentant une surface supérieure, au moins une couche diélectrique formée au-dessus de la surface supérieure du substrat et s'étendant sur une surface sous-jacente, la couche diélectrique présentant une surface supérieure et un flanc s'étendant entre la surface supérieure et la surface sous-jacente, une structure électrique monobloc en matériau conducteur de l'électricité, comprenant un élément de structure s'étendant sur la surface supérieure de la couche diélectrique et un élément d'interconnexion s'étendant à partir de l'élément de structure le long du flanc jusqu'à la surface sous-jacente, dans lequel le flanc présente une hauteur supérieure à 10µm, et la structure électrique est déposée sur la surface supérieure et le flanc de la couche diélectrique.

La structure électrique résulte d'un dépôt, notamment un dépôt électrolytique, sur la surface sous-jacente et la surface supérieure de la couche diélectrique recouvertes d'un premier revêtement de métallisation, résultant notamment d'un dépôt par pulvérisation cathodique ou par évaporation thermique, et sur le flanc recouvert d'un deuxième revêtement de métallisation, résultant notamment d'un traitement chimique du flanc.

### Description sommaire des figures

L'invention sera mieux comprise à la lecture de la description qui va suivre, donnée uniquement à titre d'exemple et faite en se référant aux dessins annexés, sur lesquels :
- les figures 1 à 7 sont des vues schématiques en section illustrant les étapes successives du procédé de fabrication d'un circuit intégré selon un premier mode de réalisation de l'invention, aboutissant à une structure électrique à un niveau ;
- la figure 8 est une photographie d'une partie du circuit intégré de la figure 7, illustrant plus particulièrement la structure électrique formée ;
- la figure 9 est une vue schématique en section analogue à la figure 7 d'un circuit intégré obtenu par un procédé de fabrication d'un circuit intégré selon un deuxième mode de réalisation ;
- les figures 10 à 17 sont des vues schématiques en section illustrant les étapes successives du procédé de fabrication d'un circuit intégré selon un troisième mode de réalisation, aboutissant à une structure électrique à deux niveaux ;
- la figure 18 est une photographie d'une section d'une partie du circuit intégré de la figure 17 ;
- la figure 19 est une photographie d'un circuit intégré obtenu par le procédé de fabrication selon le troisième mode de réalisation ;
- la figure 20 est une vue schématique en section illustrant un circuit selon une variante ; et
- la figure 21 est une vue schématique en section illustrant un circuit selon une autre variante.

### Description détaillée de l'invention

Le procédé selon l'invention permet l'intégration de structures électriques passives sur un substrat, notamment au-dessus d'une zone active ou conductrice de ce substrat. Le substrat est par exemple réalisé en matériau semi-conducteur. Ces structures électriques passives sont en particulier des composants électroniques passifs, tels que des inductances, des capacités, des résistances, des antennes ou des interconnexions. De telles interconnexions sont destinées notamment à établir des connexions électriques entre différentes régions d'une zone active ou conductrice du substrat, entre différentes zones actives ou conductrices du substrat ou entre des zones actives ou conductrices de plusieurs circuits intégrés empilés. Elles peuvent également former des éléments d'interconnexion propres à permettre la connexion électrique d'un composant électronique discret, c'est-à-dire non intégré au circuit monolithique.

Dans la suite de la description, les termes « inférieur » et « supérieur » sont utilisés par référence au substrat, le terme « inférieur » désignant la partie d'un élément la plus proche du substrat et le terme « supérieur » désignant la partie de cet élément la plus éloignée du substrat.

### Premier mode de réalisation

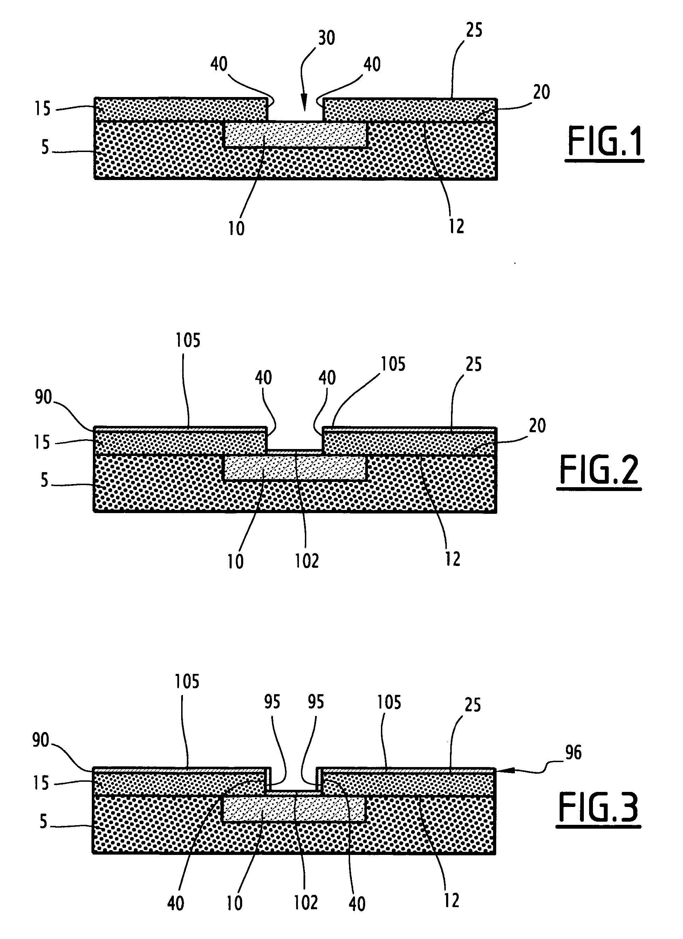

Les figures 1 à 7 illustrent les étapes successives du procédé de fabrication d'un circuit intégré monolithique selon un premier mode de réalisation de l'invention.

Le procédé est mis en oeuvre sur un substrat 5 réalisé dans un matériau semi-conducteur. Le substrat 5 est en particulier réalisé en silicium. En variante, il s'agit d'un substrat en verre ou d'un substrat souple (réalisé par exemple en PET, Polyimide...). Selon une autre variante, le substrat est réalisé en résine époxy ou à partir de polychlorobiphényle (PCB).

Il se présente sous la forme d'une plaquette d'épaisseur comprise par exemple entre 200µm et 1,5mm. Le substrat 5 comprend une surface supérieure 12 sensiblement plane.

Dans le mode de réalisation représenté, le substrat 5 comprend au moins une zone 10 active ou conductrice sur laquelle on souhaite réaliser une connexion. La zone 10 est une zone active, i.e. une zone du substrat dans laquelle a été intégré un composant électronique actif, tel qu'une diode ou un transistor, ou simplement une zone conductrice. La zone 10 est en particulier l'électrode d'un composant électronique actif, tel qu'un transistor ou une diode. La zone 10 a été préalablement intégrée dans le substrat 5 par toute méthode connue de l'homme du métier.

Dans une première étape, on forme une couche diélectrique 15 sur la surface supérieure 12 du substrat 5. La couche diélectrique 15 comprend une surface inférieure 20, une surface supérieure 25, et une ouverture d'interconnexion 30 traversant la couche diélectrique 15. L'ouverture d'interconnexion 30 est délimitée par deux flancs 40 de la couche diélectrique 15 en regard. Elle est disposée au droit de la zone 10 et débouche sur celle-ci. Chaque flanc 40 de la couche diélectrique 15 est sensiblement normal à la surface supérieure 12 du substrat 5. Dans ce contexte, une couche diélectrique est une couche isolante électriquement.

Selon une variante, chaque flanc 40 est en contre dépouille par rapport à la surface supérieure 12 du substrat 5. Dans ce cas, les flancs 40 en regard convergent l'un vers l'autre à l'écart du substrat 5.

Selon des variantes, des couches intermédiaires, en particulier métalliques, sont insérées entre la surface supérieure 12 du substrat 5 et la couche diélectrique 15. Dans ce cas, la couche diélectrique 15 s'étend sur une couche inférieure sous-jacente, et chacun de ses flancs 40 s'étend entre sa surface supérieure 25 et une surface supérieure de la couche inférieure sous-jacente.

La couche diélectrique 15 est réalisée dans un matériau polymère, propre à permettre la formation de couches d'épaisseur importante. Le matériau polymère est, en particulier d'épaisseur supérieure à 10µm, notamment supérieure à 25µm, en particulier supérieure à 80µm, et encore plus particulièrement supérieure à 100µm. Dans le mode de réalisation représenté, la constante diélectrique du matériau polymère est de 2,85. Le matériau polymère utilisé est apte à polymériser sous l'effet d'une insolation, et il existe un développeur apte à retirer sélectivement le matériau polymère non polymérisé. Le matériau polymère est avantageusement de la résine Su-8, ou un polymide tel que le Kapton^{®}, le Durimide^{®} ou l'Intervia^{®}.

Pour former la couche diélectrique 15, on enduit le matériau polymère diélectrique sur la surface supérieure 12 du substrat 5 de manière à obtenir une couche pleine plaque de matériau polymère diélectrique. Par couche pleine plaque, on entend une couche recouvrant intégralement la surface supérieure 12 du substrat 5. On structure ensuite la couche pleine plaque ainsi obtenue en retirant sélectivement le matériau diélectrique dans certaines régions par photolithographie de manière à obtenir la couche diélectrique 15 ayant la structure souhaitée. Dans le mode de réalisation illustré sur les figures 1 à 8, la structuration consiste à ouvrir par photolithographie la ou les ouvertures 30 dans la couche pleine plaque, de manière à former la couche diélectrique 15 munie des ouvertures 30 (figure 1).

La couche diélectrique 15 présente une épaisseur importante, prise entre sa surface inférieure 20 et sa surface supérieure 25, notamment une épaisseur supérieure à 10µm, plus particulièrement une épaisseur supérieure à 25µm, encore plus particulièrement supérieure à 80µm, et encore plus particulièrement supérieure à 100µm. Dans le mode de réalisation représenté sur les figures 1 à 8, la couche diélectrique 15 présente une épaisseur d'environ 70µm.

On forme ensuite une structure électrique 70 monobloc comprenant un élément de structure 75 s'étendant sur la surface supérieure 25 de la couche diélectrique 15 et un élément d'interconnexion 80 s'étendant à partir de l'élément de structure 75 au travers de l'ouverture d'interconnexion 30 le long des flancs 40 de la première couche diélectrique 15 et jusqu'à la surface supérieure 12 du substrat 5. L'élément d'interconnexion 80 s'étend donc sur toute la hauteur des flancs 40. Il connecte électriquement l'élément de structure 75 à la zone 10.

Dans le cas (non représenté) où des couches intermédiaires sont intercalées entre la surface supérieure 12 du substrat 5 et la couche diélectrique 15, l'élément d'interconnexion 80 s'étend à partir de l'élément de structure 75 le long des flancs 40 jusqu'à la surface supérieure de la couche inférieure sous-jacente. Il connecte alors électriquement l'élément de structure 75 à la couche sous-jacente, qui est par exemple une couche d'interconnexion électrique.

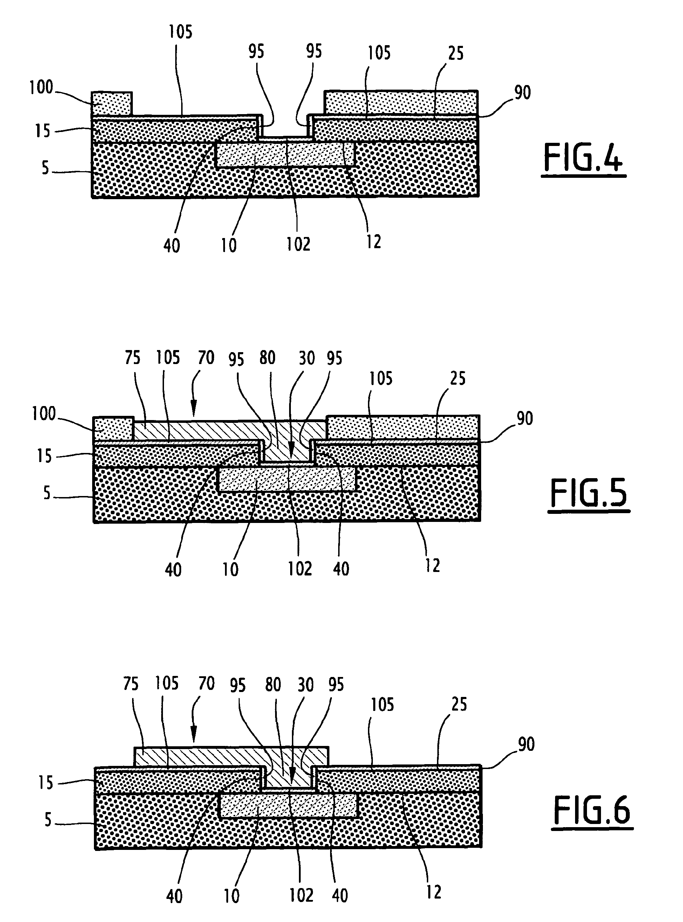

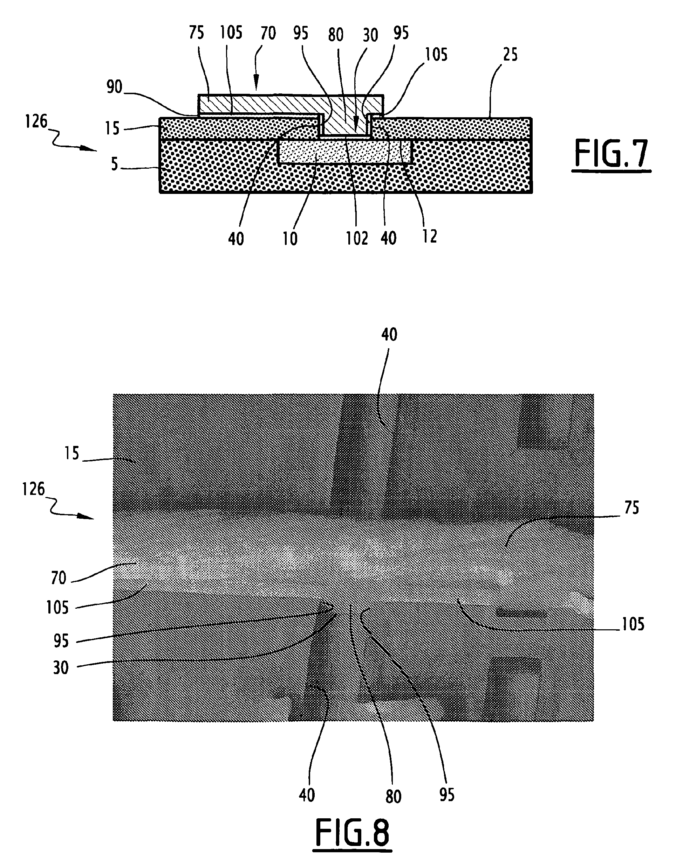

L'étape de formation de la structure électrique 70 comprend successivement :
- le dépôt d'un premier revêtement de métallisation 90 (figure 2),
- le dépôt d'un deuxième revêtement de métallisation 95 (figure 3), le premier et le deuxième revêtement de métallisation 90, 95 formant conjointement une base de croissance électrolytique 96 continue conductrice de l'électricité ;
- le dépôt d'une couche de résine 100 (figure 4) ;
- le dépôt par croissance électrolytique de la structure électrique 70 (figure 5) ;
- le retrait de la couche de résine 100 (figure 6) ; et
- la gravure du premier revêtement de métallisation 90 dans les régions dans lesquelles il n'est pas recouvert par la structure électrique 70 (figure 7).

Ainsi, pour former la structure électrique 70, on dépose le premier revêtement de métallisation 90 sur les surfaces supérieures dégagées, c'est-à-dire en particulier sur la surface supérieure 25 de la couche diélectrique 15 et sur la surface supérieure 12 du substrat 5 au travers de l'ouverture d'interconnexion 30. Le premier revêtement de métallisation 90 comprend une première partie 102 recouvrant la surface supérieure 12 du substrat 5 et une deuxième partie 105 s'étendant sur la surface supérieure 25 de la couche diélectrique 15.

Il est réalisé dans un matériau métallique, en particulier dans un matériau conducteur de l'électricité, propre à former une couche d'accrochage et à promouvoir l'adhésion du matériau constituant la structure électrique 70 par croissance électrolytique. Le premier revêtement de métallisation 90 est en particulier réalisé par un dépôt successif de deux couches. La première couche est une base d'accrochage réalisée par exemple en titane, chrome ou en alliage titane/tungstène.... En variante, la base d'accrochage est réalisée en tantale ou en tungstène. La deuxième couche est une base de croissance pour le dépôt électrolytique réalisée par exemple en or, cuivre ou nickel ...

Le premier revêtement de métallisation 90 est une couche fine, d'épaisseur de l'ordre de 0,25µm.

Le premier revêtement de métallisation 90 est déposé par un procédé classique de dépôt d'un matériau métallique connu de l'homme du métier, en particulier par pulvérisation cathodique ou par évaporation thermique. Lors d'un tel dépôt, les surfaces supérieures dégagées sont atteintes facilement par le matériau métallique constituant le premier revêtement 90, et l'on recouvre ainsi ces surfaces de manière continue. En revanche, en raison de l'épaisseur importante de la couche diélectrique 15 et de la géométrie des flancs 40, les procédés classiques de dépôt d'un revêtement métallique ne permettent pas un recouvrement correct des flancs 40 par le matériau métallique.

Afin de former la base de croissance électrolytique 96 continue, on dépose (figure 3) le deuxième revêtement de métallisation 95 sur les flancs 40 de chaque ouverture d'interconnexion 30. Le deuxième revêtement de métallisation 95 forme ainsi une connexion électrique entre la première partie 102 et la deuxième partie 105 du premier revêtement de métallisation 90.

Compte tenu de la topologie des flancs 40, qui sont normaux à la surface supérieure 12 ou en contre dépouille, le deuxième revêtement de métallisation 95 est déposé par traitement chimique des flancs 40 ou encore « métallisation par dépôt chimique ». Ce traitement chimique des flancs 40 de la couche diélectrique 15 comprend en particulier :
- la préparation des flancs 40, consistant en leur nettoyage afin de les débarrasser de résidus éventuellement préjudiciables lors des étapes suivantes du traitement chimique ;
- le dépôt sur les flancs 40 ainsi préparés d'un initiateur favorisant l'adhérence des ions du métal (Palladium) constituant le revêtement de métallisation 95 et permettant la catalyse de ces ions métalliques de manière à former le deuxième revêtement de métallisation 95 et ainsi à rendre conducteurs les flancs 40.

Chacune de ces phases est réalisée par immersion dans un bain contenant une solution adaptée.

Le second revêtement de métallisation 95 est par exemple réalisé selon le procédé Envision® de la société Cookson Electronics optimisé.

Le deuxième revêtement de métallisation 95 est réalisé dans un matériau présentant des propriétés similaires au matériau du premier revêtement de métallisation 90.

On dépose ensuite (figure 4) la couche de résine 100 sur le premier revêtement de métallisation 90 de manière à recouvrir les régions de ce revêtement 90 qui ne sont pas destinées à être mises en contact avec la structure électrique 70 et à laisser découvertes les régions du premier revêtement de métallisation 90 destinées à être mises en contact avec la structure électrique 70. On forme ainsi un moule pour le dépôt de la structure électrique 70, propre à limiter l'extension du matériau conducteur de l'électricité lors de l'étape de dépôt électrolytique, le matériau conducteur de l'électricité ne pouvant se déposer sur les zones du premier revêtement de métallisation 90 recouvertes par la couche de résine 100.

Ainsi, dans le premier mode de réalisation, la couche de résine 100 recouvre des zones de la deuxième partie 105 du premier revêtement de métallisation 90, c'est-à-dire des zones du premier revêtement de métallisation 90 au droit de la première couche diélectrique 15.

La couche de résine 100 ayant la structure souhaitée est obtenue par tout procédé adapté connu de l'homme du métier, en particulier par photolithographie. La couche de résine 100 présente une épaisseur importante, en particulier une épaisseur comprise entre 10µm et 200µm. Dans l'exemple représenté, elle a une épaisseur environ égale à 90µm.

La résine formant la couche de résine 100 est en particulier une résine photosensible de type négatif ayant une résolution de 1 pour 10, c'est-à-dire que la plus petite largeur des tranchées pouvant être obtenues par photolithographie à partir d'une couche de résine d'épaisseur environ égale à 100µm est de 10µm. Il est ainsi possible de former des motifs de largeur supérieure ou égale à 10µm pour une épaisseur de résine de 100µm.

On forme ensuite (figure 5) la structure électrique 70 en déposant simultanément, par un procédé de dépôt électrolytique, le matériau conducteur de l'électricité sur les zones de la base de croissance électrolytique 96 continue non recouvertes par la couche de résine 100. Du fait de sa continuité, la base de croissance électrolytique 96 est propre à conduire un courant électrolytique sur toute sa surface, et à permettre ainsi la formation simultanée et d'un seul tenant de l'élément d'interconnexion 80 et de l'élément de structure 75 par dépôt simultané du matériau conducteur de l'électricité sur une zone de la surface supérieure 12 du substrat 5 délimitée par l'ouverture d'interconnexion 30, sur la surface supérieure 25 de la couche diélectrique 15, et sur les flancs 40 lors de la croissance électrolytique du matériau conducteur de l'électricité.

Ainsi, dans le mode de réalisation représenté sur les figures 1 à 8, on dépose simultanément le matériau conducteur de l'électricité sur la surface supérieure 12 du substrat 5 à travers l'ouverture d'interconnexion 30, sur la surface supérieure 25 de la couche diélectrique 15, et sur les flancs 40 de manière à former simultanément le premier élément de structure 75 et l'élément d'interconnexion 80.

On forme ainsi, en une seule étape de croissance électrolytique, la structure électrique 70 monobloc.

La structure électrique 70 est réalisée dans un matériau conducteur de l'électricité, et propre à être déposé par électrolyse. Elle est avantageusement réalisée en cuivre. En variante, elle est réalisée en or ou dans des alliages de métaux autorisant un dépôt électrolytique. L'élément de structure 75 forme par exemple tout ou partie d'un composant électronique, notamment d'un composant électronique passif tel qu'une inductance. Il peut également former une ligne d'interconnexion, destinée à connecter entre elles différentes régions de la zone 10.

L'épaisseur de l'élément de structure 75 dépend de sa fonction électronique. Elle dépend également de l'application du circuit. A titre d'exemple, des éléments de structure seront prévus avec des épaisseurs plus élevées dans un circuit amplificateur de puissance que celles qui seront nécessaires pour des éléments de structures d'un circuit amplificateur bas niveau ou faible bruit. A titre indicatif, l'épaisseur d'un élément de structure 75 est par exemple comprise entre 5µm et 150µm. Plus particulièrement, l'épaisseur d'un élément de structure 75 est par exemple comprise entre 5 et 200 µm.

Après avoir formé la structure électrique 70, on dissout (figure 6) la couche de résine 100, par exemple par immersion de l'ensemble représenté sur la figure 5 dans un bain propre à dissoudre sélectivement la couche de résine 100.

Enfin, on grave (figure 7) la base de croissance électrolytique 96 continue dans les zones dans lesquelles elle n'est pas recouverte par la structure électrique 70, c'est-à-dire dans les zones recouvertes précédemment par la couche de résine 100. Cette gravure est réalisée par tout procédé de gravure adapté, notamment par gravure chimique.

On obtient ainsi un circuit intégré monolithique 126 tel que représenté sur la figure 7, et comprenant un niveau d'interconnexion formé par l'élément de structure 75.

La figure 8 est une photographie représentant une partie du circuit intégré monolithique 126 obtenu par le procédé selon le premier mode de réalisation, et montrant plus particulièrement la structure électrique monobloc 70 formée au-dessus de la zone 10.

En option, lors de sa formation, la couche diélectrique 15 est structurée de manière à ne recouvrir qu'une zone limitée de la surface supérieure 12 du substrat 5. La formation d'une couche diélectrique 15 ne s'étendant que sur une région limitée de la surface supérieure du substrat 5 ou d'une couche sous-jacente est avantageuse. En effet, le matériau diélectrique tend à se rétracter lors de la polymérisation, ce qui engendre des contraintes mécaniques importantes sur le substrat 5, qui, du fait de sa faible épaisseur, est très fragile. La mise en oeuvre d'une couche diélectrique 15 d'extension plus limitée réduit les contraintes mécaniques exercées sur le substrat 5.

Une telle structuration est réalisée par photolithographie, par exemple au cours de l'étape de photolithographie aboutissant à la réalisation de l'ouverture d'interconnexion 30.

### Deuxième mode de réalisation

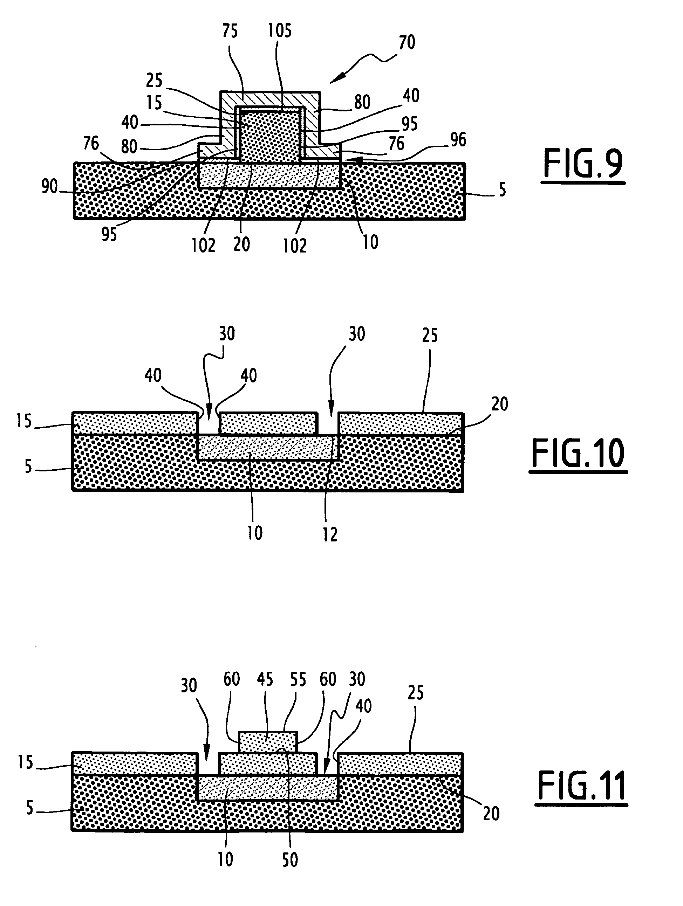

La figure 9 illustre une vue en section d'un circuit intégré monolithique obtenu par le procédé selon le deuxième mode de réalisation. Le circuit intégré obtenu diffère de celui obtenu par le procédé selon le premier mode de réalisation en ce que la couche diélectrique 15 est dépourvue d'ouverture d'interconnexion 30. Dans ce mode de réalisation, la couche diélectrique 15 définit une nervure présentant des flancs latéraux 40. Elle s'étend sur la zone active ou conductrice 10 en laissant deux régions de la zone 10 découvertes, à l'aplomb de ses flancs 40. Chaque flanc 40 présente une hauteur supérieure à 10µm, et en particulier supérieure à 50µm. Dans l'exemple représenté, cette hauteur est environ égale à 80µm.

L'étape de formation de la structure électrique 70 monobloc comprend :
- le dépôt du premier revêtement de métallisation 90 sur les surfaces supérieures dégagées du substrat 5 et de la couche diélectrique 15 de manière à former la première partie 102 sur la surface supérieure 12 du substrat 5, et la deuxième partie 105 sur la surface supérieure 25 de la première couche diélectrique 15 ;
- le dépôt du deuxième revêtement de métallisation 95 sur les flancs 40 de la couche diélectrique 15, de manière à former la base de croissance électrolytique 96 continue.
- le dépôt de la couche de résine 100 sur les régions de la première partie 102 du premier revêtement de métallisation 90 qui ne sont pas destinées à être recouvertes par la structure électrique 70 ;
- le dépôt électrolytique de la structure électrique 70 ;
- le retrait de la couche de résine 100 ; et
- la gravure du premier revêtement de métallisation 90 dans les régions dans lesquelles il n'est pas recouvert par la structure électrique 70.

Lors de l'étape de dépôt électrolytique, on obtient une structure électrique 70 monobloc comprenant l'élément de structure 75 s'étendant sur la couche diélectrique 15, deux éléments d'interconnexion 80 s'étendant chacun le long d'un flanc 40 à partir de l'élément de structure 75 et jusqu'à la surface supérieure 12 du substrat 5. Elle comprend en outre, pour chaque élément d'interconnexion 80, un élément de structure 76 s'étendant sur la surface supérieure 12 du substrat 5 au droit des deux régions dégagées de la zone 10 à partir de l'élément d'interconnexion 80 correspondant. L'élément de structure 75, les éléments d'interconnexion 80, et les éléments de structure 76 sont formés simultanément par dépôt électrolytique. Les éléments de structure 75 et 76 présentent par exemple une épaisseur comprise entre 5 et 200 µm.

### Troisième mode de réalisation

Les figures 10 à 19 illustrent un circuit intégré monolithique 125 obtenu par le procédé selon le troisième mode de réalisation. Ce procédé diffère du procédé selon le premier mode de réalisation en ce que l'on forme une structure électrique à plusieurs niveaux. Pour ce faire, on forme (figure 11) une deuxième couche diélectrique 45 superposée à la couche diélectrique 15, qualifiée, dans ce mode de réalisation, de première couche diélectrique.

On forme la deuxième couche diélectrique 45 immédiatement après l'étape de formation de la première couche diélectrique 15 (figure 10). La deuxième couche diélectrique 45 ne recouvre que partiellement la première couche diélectrique 15. Ainsi, la deuxième couche diélectrique 45 laisse des régions de la première couche diélectrique 15 découvertes. La structure particulière de la deuxième couche diélectrique 45 est obtenue, de manière connue, par photolithographie.

Les deux couches 15, 45 forment conjointement une structure diélectrique. La première couche diélectrique 15 comprend deux ouvertures d'interconnexion 30, délimitées chacune par deux flancs 40 en regard de la première couche diélectrique 15. Chaque ouverture d'interconnexion 30 est disposée au droit de la zone active ou conductrice 10 et débouche sur celle-ci. La deuxième couche diélectrique 45 est disposée entre les ouvertures d'interconnexion 30. La structure diélectrique formée par la première et la deuxième couche diélectrique 15, 45 est en gradin.

La deuxième couche diélectrique 45 comprend une surface inférieure 50, une surface supérieure 55 et au moins un flanc 60 s'étendant entre la surface supérieure 55 et la surface supérieure de la couche diélectrique sous-jacente, c'est-à-dire de la première couche diélectrique 15. Chaque flanc 60 présente une hauteur supérieure à 10µm, en particulier supérieure à 25µm.

Dans ce mode de réalisation, chaque flanc 60 a une hauteur environ égale à 50µm, et chaque flanc 40 de la première couche diélectrique 45 a une hauteur environ égale à 30µm. La structure diélectrique présente ainsi en tout point une hauteur supérieure à 10µm, et, dans la zone dans laquelle la première et la deuxième couche diélectrique 15, 45 sont superposées, une hauteur environ égale à 80µm.

Dans le mode de réalisation représenté, chaque flanc 60 est sensiblement normal à la surface supérieure 55 de la deuxième couche diélectrique 45, et à la surface supérieure 12 du substrat 5. Selon une variante, chaque flanc 60 forme un angle aigu avec la surface supérieure 12 du substrat 5.

La deuxième couche diélectrique 45 est formée dans un matériau polymère présentant les mêmes propriétés que le matériau de la première couche diélectrique 15, par exemple dans le même matériau. Elle est avantageusement réalisée en polymère Su-8.

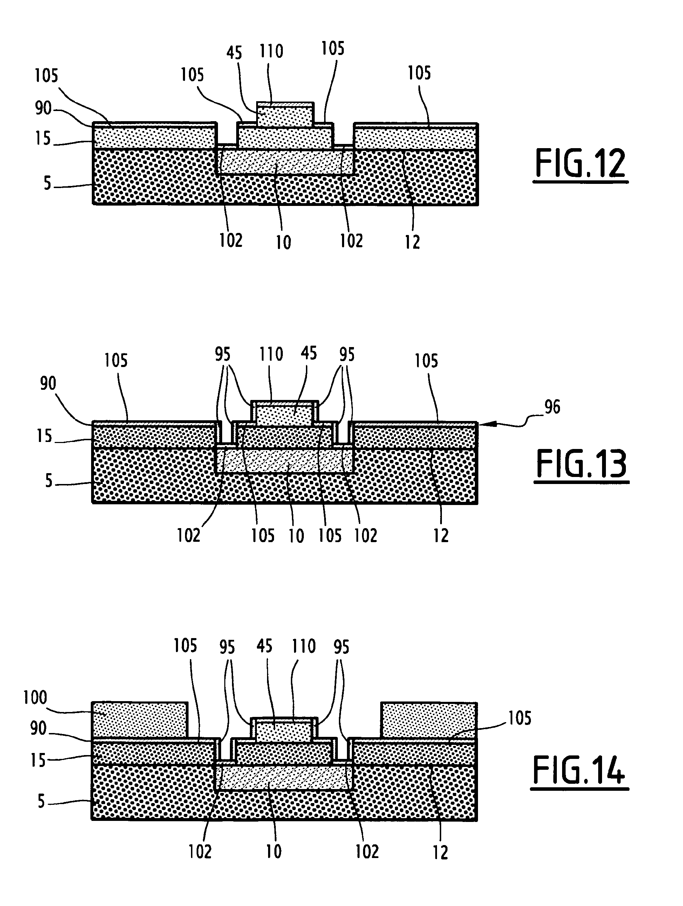

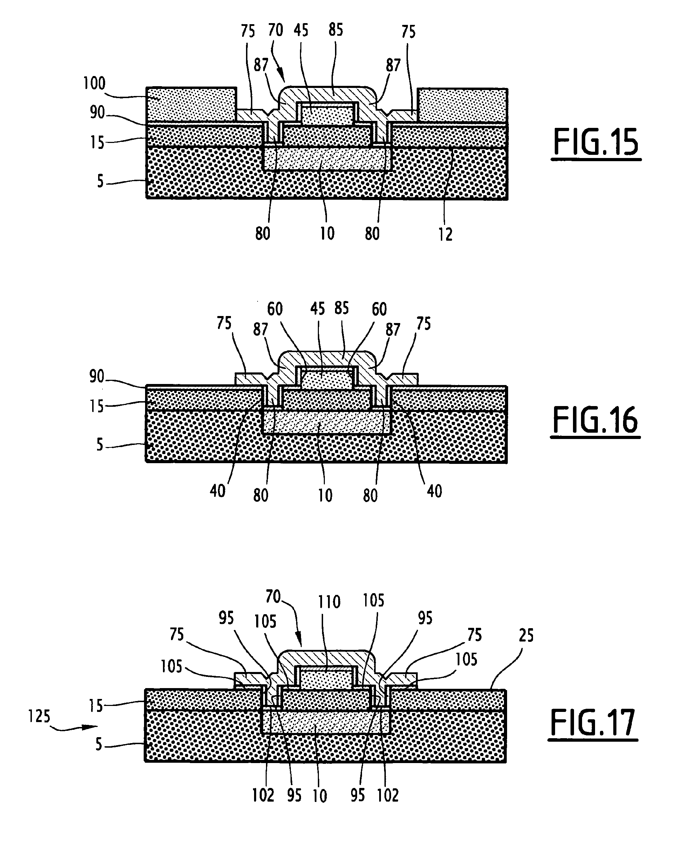

L'étape de formation de la structure électrique 70 comprend :
- le dépôt (figure 12) du premier revêtement de métallisation 90 sur les surfaces supérieures dégagées du substrat 5, de la première couche diélectrique 15, et de la deuxième couche diélectrique 45 de manière à former la première partie 102 sur la surface supérieure 12 du substrat 5 au travers des ouvertures d'interconnexion 30, la deuxième partie 105 sur la surface supérieure 25 dégagée de la première couche diélectrique 15, et une troisième partie 110 sur la surface supérieure 55 de la deuxième couche diélectrique 45 ;
- le dépôt (figure 13) du deuxième revêtement de métallisation 95 sur les flancs 40 de la première couche diélectrique 15, et sur les flancs 60 de la deuxième couche diélectrique 45, de manière à former la base de croissance électrolytique 96 continue.
- le dépôt (figure 14) de la couche de résine 100 sur les régions de la deuxième partie 105 du premier revêtement de métallisation 90 qui ne sont pas destinées à être recouvertes par la structure électrique 70 ;
- le dépôt électrolytique (figure 15) de la structure électrique 70 ;
- le retrait de la couche de résine 100 (figure 16) ; et
- la gravure (figure 17) du premier revêtement de métallisation 90 dans les régions dans lesquelles il n'est pas recouvert par la structure électrique 70.

Ces sous-étapes de l'étape de formation de la structure électrique 70 monobloc sont similaires à celles décrites en regard du premier mode de réalisation.

A l'issue de l'étape de dépôt électrolytique, on obtient (figure 15) une structure électrique 70 monobloc comprenant :
- deux premiers éléments de structure 75 s'étendant sur la première couche diélectrique 15, de part et d'autre de la deuxième couche diélectrique 45 ;
- deux éléments d'interconnexion 80, qualifiés de premiers éléments d'interconnexion 80, s'étendant chacun au travers de l'une des ouvertures d'interconnexion 30 à partir d'un premier élément de structure 75 respectif et jusqu'à la surface supérieure 12 du substrat 5,
- un deuxième élément de structure 85 s'étendant sur la deuxième couche diélectrique 45, et
- deux deuxièmes éléments d'interconnexion 87, s'étendant chacun le long d'un flanc 60 de la deuxième couche diélectrique 45 à partir du deuxième élément de structure 85 jusqu'à la surface supérieure de la couche diélectrique sous-jacente, qui est, dans ce cas, la surface supérieure 25 de la première couche diélectrique.

Les deuxièmes éléments d'interconnexion 87 recouvrent le flanc 60. Ils connectent électriquement entre eux le premier et le deuxième élément de structure 75, 85.

A l'issue de l'étape de gravure (figure 17), on a formé un circuit intégré monolithique 125 comprenant au moins un substrat 5 réalisé par exemple en matériau semi-conducteur, ainsi qu'au moins deux niveaux d'interconnexions électriques définis chacun par la surface supérieure d'une couche diélectrique, et constitués respectivement par le premier et le deuxième élément de structure 75, 85. Les niveaux d'interconnexions sont reliés électriquement entre eux par les éléments d'interconnexion 87. Le premier et le deuxième élément de structure 75, 85 forment par exemple tout ou partie de composants électroniques, notamment des composants électroniques passifs tels que des inductances. Ils peuvent également former des lignes d'interconnexion, destinées à connecter entre elles différentes zones actives ou conductrices 10 ou différentes régions d'une même zone active ou conductrice 10. L'épaisseur de chacun des éléments de structure 75 et 85 varie en fonction de sa fonction électronique. Les premier et deuxième éléments de structure 75, 85 présentent par exemple des épaisseurs comprises entre 5 et 200 µm.

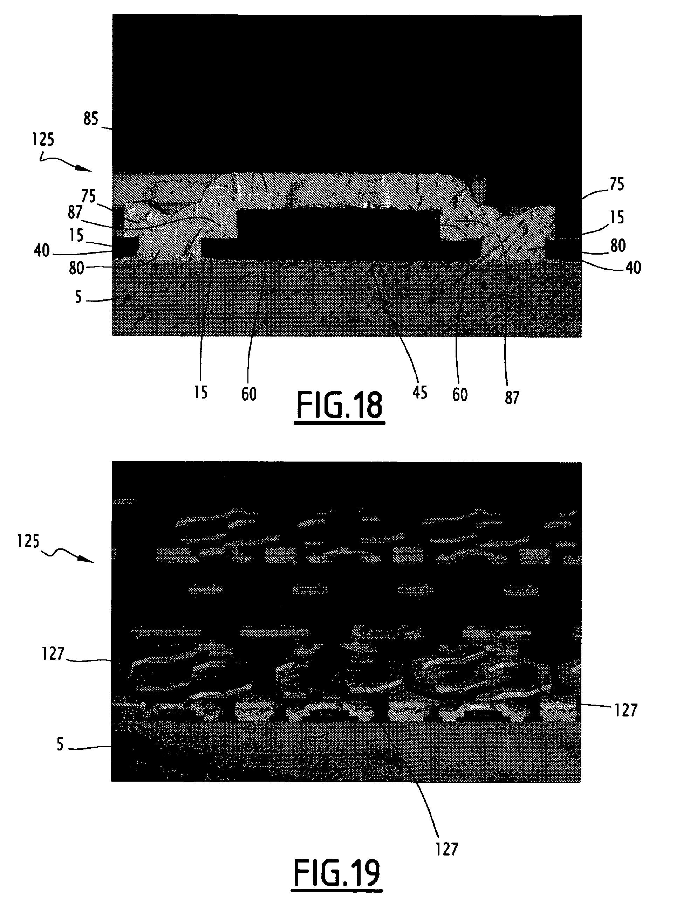

La figure 18 est une photographie d'une section d'une partie du circuit intégré 125, la structure électrique 70 monobloc formant deux niveaux d'interconnexions au-dessus de la zone active 10 du substrat 5, et comprenant deux premiers éléments d'interconnexion 80 réalisant une connexion à la zone active 10.

La figure 19 est une photographie illustrant le circuit intégré 125 obtenu par le procédé selon l'invention, la structure électrique 70 formant des inductances 127.

### Variantes

Selon une variante, on superpose plus de deux couches diélectriques. Dans ce cas, le procédé de fabrication comprend, après la formation de la deuxième couche diélectrique 45, et avant le dépôt du premier revêtement de métallisation 90, des étapes intermédiaires de formation de couches diélectriques additionnelles, chaque couche diélectrique additionnelle étant formée sur la couche diélectrique sous-jacente. Chaque couche diélectrique additionnelle comprend une surface supérieure, une surface inférieure, et des flancs s'étendant entre sa surface supérieure et la surface supérieure de la couche diélectrique sous-jacente. Selon un mode de réalisation chaque couche diélectrique présente un flanc de hauteur supérieure à 10µm.

Dans ce cas, le premier revêtement de métallisation 90 est déposé en outre sur les surfaces supérieures libres de chaque couche diélectrique additionnelle, et le deuxième revêtement de métallisation 95 est déposé en outre sur les flancs de chaque couche diélectrique additionnelle.

La surface supérieure de chaque couche diélectrique additionnelle définit un niveau d'interconnexion, la structure électrique comprenant un élément de structure sur chacun de ces niveaux d'interconnexion, ainsi que, pour chacun de ces éléments de structure, un élément d'interconnexion s'étendant à partir de l'élément de structure correspondant et jusqu'à une surface supérieure de la couche diélectrique sous-jacente, de manière à connecter cet élément de structure à un élément de structure inférieur.

La structure électrique 70 monobloc formée en une seule étape de croissance électrolytique comprend outre les premier et deuxième éléments d'interconnexion 80, 87 et les premier et deuxième éléments de structure 75, 85, au moins un élément de structure additionnel s'étendant sur l'une des couches diélectriques additionnelles, en particulier sur la couche diélectrique supérieure, c'est-à-dire la dernière couche diélectrique appliquée. Elle comprend en outre au moins un élément d'interconnexion additionnel, s'étendant le long du flanc de la couche diélectrique additionnelle depuis l'élément de structure additionnel jusqu'à la surface supérieure d'une couche diélectrique sous-jacente. Avantageusement la structure électrique 70 s'étend sur chacune des couches diélectriques additionnelles. Dans ce cas, la structure diélectrique monobloc 70 formée comprend autant de niveaux d'interconnexion que de couches diélectriques.

Selon une autre variante du procédé selon les premier, deuxième et troisième modes de réalisation selon l'invention, une ou plusieurs couches intermédiaires, en particulier métalliques, sont interposées entre la surface supérieure 12 du substrat 5 et la première couche diélectrique 15. Cette ou ces couche(s) intermédiaire(s) forment par exemple des couches d'interconnexion, auxquelles la structure électrique 70 est connectée par l'intermédiaire de l'élément d'interconnexion 80. Dans ce cas, la surface sous-jacente sur laquelle s'étend la première couche diélectrique 15 est la surface supérieure de la couche intermédiaire immédiatement sous-jacente à la première couche diélectrique 15.

Selon une autre variante, le circuit intégré fabriqué par le procédé selon l'invention est un empilement d'au moins deux sous circuits intégrés, la structure électrique 70 monobloc permettant notamment de connecter entre eux ces sous circuits au sein de l'empilement.

### Avantages de l'invention

Le procédé selon l'invention permet d'obtenir, avec un nombre réduit d'étapes technologiques, un circuit monolithique intégrant des structures passives, réalisées sur une couche épaisse de matériau isolant diélectrique, présentant de très bonnes propriétés électriques, en particulier des inductances faibles pertes et de bon facteur de qualité. Ces bonnes propriétés électriques proviennent de l'utilisation de couches épaisses d'isolant électrique qu'il est possible d'implémenter sur un plan métallique réalisant un écran électrique du substrat.

La réduction importante du nombre d'étapes par rapport aux procédés classiques provient notamment du fait qu'il permet de former une structure électrique s'étendant sur plusieurs niveaux en une seule étape de dépôt par électrolyse, même lorsque la couche de diélectrique à enjamber est d'épaisseur importante. Ainsi, ce procédé ne nécessite pas d'effectuer, pour chaque niveau d'interconnexion, un dépôt de couche d'accrochage et de résine. En outre, comme la couche diélectrique est formée avant le dépôt de la structure électrique, il n'y a pas d'obstacles lors de l'enduction de cette couche, ce qui permet d'obtenir directement une surface supérieure sensiblement plane, sans qu'il soit nécessaire d'effectuer des opérations additionnelles de polissage.

L'utilisation de cette technologie se traduit donc par une augmentation des rendements de fabrication et une diminution importante des coûts.

Le dépôt en une seule étape de la structure électrique, comportant un ou plusieurs niveaux d'interconnexion, enjambant d'épaisses couches diélectriques est rendu possible par la réalisation du deuxième revêtement de métallisation sur les flancs des couches diélectriques qui permet d'obtenir une base de croissance électrolytique continue sur plusieurs niveaux. Il n'est alors plus nécessaire de déposer une couche d'accrochage et une couche de résine pour chaque niveau d'interconnexion à réaliser, avant de procéder au dépôt électrolytique de ce niveau d'interconnexion. Le procédé de fabrication est ainsi simplifié. Le procédé selon l'invention présente un intérêt particulier lorsque l'on utilise des résines diélectriques à flancs droits, c'est-à-dire formant lors de leur structuration, des flancs perpendiculaires à la surface supérieure de la couche diélectrique.

La structure électrique 70 formée est monobloc, c'est-à-dire qu'elle résulte d'une seule étape de croissance électrolytique. De ce fait, elle ne comprend pas de joints entre ses différentes parties, susceptibles de la fragiliser et d'influencer ses propriétés électriques. Elle est en particulier formée intégralement en cuivre, et ne comprend pas d'inserts réalisés dans des matériaux conducteurs de l'électricité différents. Ainsi, sa tenue mécanique est améliorée.

Grâce à l'utilisation de couches diélectriques isolantes de forte épaisseur éventuellement déposées sur un plan métallique d'écrantage en surface du substrat, les structures passives intégrées par ce procédé sont peu ou pas sensibles à la faible résistivité du substrat, et leurs performances électriques sont améliorées.

Le procédé selon l'invention permet ainsi la fabrication de circuits intégrés, comprenant des structures électriques, formant des structures passives, en particulier d'interconnexions et d'inductances très faibles pertes. Il permet de concevoir et de réaliser des amplificateurs de puissance RF et micro-ondes de rendement de puissance élevés et présentant donc une consommation réduite. Il peut aussi permettre d'implémenter une antenne directement sur le circuit intégré.

L'utilisation d'une résine de résolution élevée permet d'obtenir des motifs de faible largeur avec des épaisseurs de couches de résine élevées et élargit le domaine d'application du procédé, tout en offrant un plus grand degré de liberté en matière de conception de composants.

Enfin, la structuration de la couche diélectrique isolante permet d'aboutir à des structures électriques passives robustes d'un point de vue mécanique, qui présentent de bonnes performances électriques, en particulier de faibles pertes.

L'utilisation de cette technologie n'est pas limitée à des substrats semiconducteurs, elle peut être appliquée à d'autres types de substrats comme les verres, les substrats souples (PET, Polyimide...).

L'invention concerne également un circuit intégré obtenu selon le procédé de l'invention.

Dans les premier, deuxième et troisième modes de réalisation et les variantes, les flancs 40 et/ou 60 présentent par exemple une épaisseur comprise entre 10 µm et 500 µm.

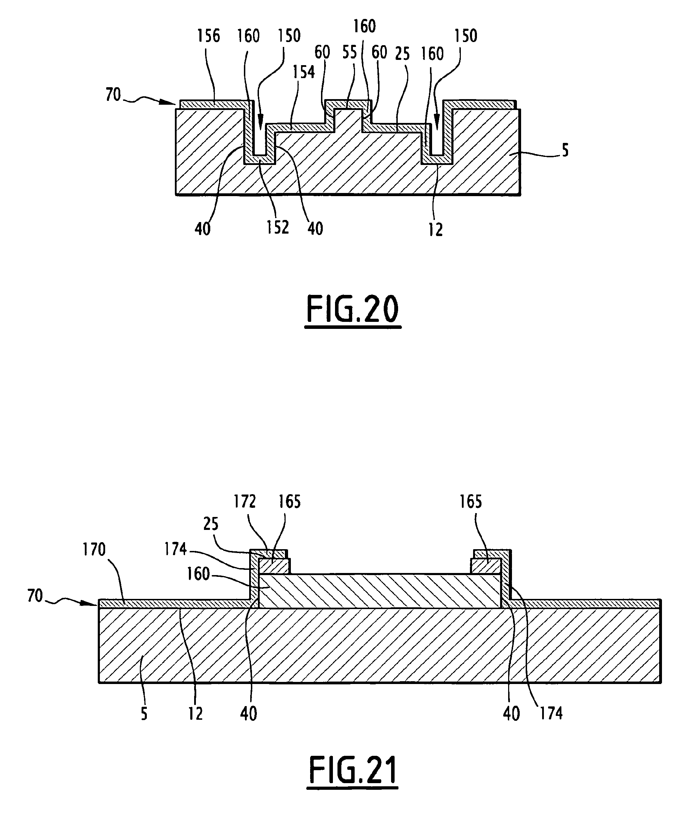

Les figures 20 et 21 illustrent des circuits obtenus par des procédés selon des variantes. Les références numériques des éléments analogues à ceux des premier et deuxième modes de réalisation ont été conservées.

Le circuit illustré sur la figure 20 diffère de celui selon les premier et deuxième modes de réalisation en ce que la structure électrique 70 n'est pas formée sur une couche diélectrique. Selon cette variante, on fournit, dans une première étape, un substrat 5 usiné. Le substrat 5 est par exemple un substrat en silicium. Il est usiné de manière à présenter une première surface 12 et une deuxième surface 25 sensiblement parallèles entre elles. Les première et deuxième surfaces 12, 25 sont espacées l'une de l'autre selon la direction normale à ces surfaces 12, 25. Un flanc 40 s'étend entre la première surface 12 et la deuxième surface 25. Dans le mode de réalisation représenté, les flancs 40 sont sensiblement normaux à la première surface 12.

Dans l'exemple représenté, le substrat 5 comprend des flancs 40 sensiblement parallèles entre eux s'étendant chacun vers le haut à partir d'une même surface, par exemple à partir de la première surface 12. Ces flancs 40 délimitent avec la partie de la première surface 12 située entre les flancs 40 parallèles un puits 150 dans le substrat 5.

Dans l'exemple représenté sur la figure 20, le substrat 5 comprend en outre une surface additionnelle 55 sensiblement parallèle aux première et deuxième surfaces 12, 25. La surface additionnelle 55 est espacée de la deuxième surface 25 selon la direction normale à cette surface. Un flanc 60 s'étend entre la surface additionnelle 55 et la deuxième surface 25.

Selon un mode de réalisation, les flancs 40 et/ou 60 présentent une épaisseur comprise entre 10 µm et 500 µm.

Le procédé de fabrication du circuit sur le substrat 5 usiné est analogue au procédé décrit en référence aux premier et deuxième modes de réalisation, mais ne comprend pas d'étape de formation de couche diélectrique. Le premier revêtement de métallisation est formé directement sur les première et deuxième surfaces 12, 25 et éventuellement sur la surface additionnelle 55 du substrat 5 et le deuxième revêtement de métallisation est formé sur les flancs 40, 60 du substrat 5 pour former la base de croissance électrolytique continue 96.

A l'issue de ce procédé, on obtient un circuit comprenant une structure électrique 70 monobloc, c'est-à-dire formée en une seule étape de dépôt par électrolyse. Cette structure électrique monobloc 70 comprend des éléments de structure 152, 154, 156 s'étendant respectivement sur la première surface 12, la deuxième surface 25 et la surface additionnelle 55 du substrat 5 et des éléments d'interconnexion 160, s'étendant le long des flancs 40, 60 entre les éléments de structure 152, 154 et 156.

Un tel circuit est notamment utilisé pour des applications microfluidiques.

Le circuit illustré sur la figure 21 diffère du circuit selon les premier et deuxième modes de réalisation en ce que la structure électrique 70 n'est pas formée sur une couche diélectrique. Selon cette variante, on fournit dans une première étape un substrat 5 comprenant une puce 160 rapportée sur la surface supérieure 12 du substrat 5, par exemple par collage. La puce 160 présente une surface supérieure 25 et des flancs 40 s'étendant entre la surface supérieure 25 et la surface supérieure 12 du substrat 5. La puce 160 comprend, sur sa surface supérieure 25, des plots de connexion 165.

En option, une couche intermédiaire est intercalée entre la puce et le substrat 5. Dans ce cas, les flancs 40 s'étendent entre la surface supérieure 25 de la puce 160 et la surface supérieure de la couche sous-jacente.

Dans le mode de réalisation représenté, les flancs 40 sont sensiblement normaux à la surface supérieure 12 du substrat 5.

Selon un mode de réalisation, les flancs 40 présentent une épaisseur comprise entre 10 µm et 500 µm.

Le procédé de fabrication du circuit sur le substrat 5 muni de la puce 160 est analogue au procédé décrit en référence aux premier et deuxième modes de réalisation mais ne comprend pas d'étape de formation de couche diélectrique. Le premier revêtement de métallisation 90 est formé sur la surface supérieure 12 du substrat 5 (éventuellement sur la surface supérieure de la couche sous-jacente) et sur la surface supérieure 25 de la puce 160. Le deuxième revêtement de métallisation 95 est formé sur au moins un flanc 40 de manière à former avec le premier revêtement de métallisation 90 la base de croissance électrolytique continue 96.

La structure électrique monobloc 70 formée à l'issue du procédé comprend au moins un premier élément de structure 170 s'étendant sur la surface supérieure 12 du substrat 5 et un deuxième élément de structure 172 s'étendant sur la surface supérieure 25 de la puce 160. Elle comprend en outre un élément d'interconnexion 174 s'étendant entre le premier élément de structure 170 et le deuxième élément de structure 172 de manière à les connecter électriquement entre eux.

Un tel circuit permet par exemple de connecter électriquement entre elles plusieurs puces 160 rapportées sur le substrat 5.

De manière plus générale, l'invention concerne un procédé de fabrication d'un circuit, du type comprenant les étapes de :
- fournir un ensemble comprenant une première surface et une deuxième surface sensiblement parallèles entre elles et un flanc s'étendant entre la première surface et la deuxième surface,
- former une structure électrique monobloc en matériau conducteur de l'électricité, comprenant un élément de structure s'étendant sur la deuxième surface et un élément d'interconnexion s'étendant à partir de l'élément de structure le long du flanc jusqu'à la première surface,
dans lequel le flanc présente une hauteur supérieure à 10µm, et la structure électrique est formée par dépôt du matériau conducteur de l'électricité en déposant simultanément l'élément de structure sur la deuxième surface supérieure de la couche diélectrique et l'élément d'interconnexion sur le flanc.

Les première et deuxième surfaces sont espacées selon la direction normale aux première et deuxième surfaces.

Selon une variante, l'ensemble comprend en outre au moins une surface additionnelle sensiblement parallèle aux première et deuxième surfaces, un flanc s'étendant entre la première surface et la deuxième surface et un flanc s'étendant entre la deuxième surface et la surface additionnelle, et au moins l'un des flancs présentant une hauteur supérieure à 10µm,
et dans lequel on forme la structure électrique en déposant simultanément un élément de structure s'étendant sur la deuxième surface et un élément de structure s'étendant sur la surface additionnelle et un élément d'interconnexion s'étendant le long des flancs à partir de l'élément de structure s'étendant sur la troisième surface et/ou la deuxième surface jusqu'à respectivement la deuxième surface ou la première surface.

## Revendications

1. Procédé de fabrication d'un circuit, du type comprenant les étapes de :
- fournir un ensemble comprenant une première surface (12) et une deuxième surface (25) sensiblement parallèles entre elles et un flanc (40) s'étendant entre la première surface (12) et la deuxième surface (25),
- former une structure électrique (70) monobloc en matériau conducteur de l'électricité, comprenant un élément de structure (75) s'étendant sur la deuxième surface (25) et un élément d'interconnexion (80) s'étendant à partir de l'élément de structure (75) le long du flanc (40) jusqu'à la première surface (12),
dans lequel le flanc (40) présente une hauteur supérieure à 10µm, et la structure électrique (70) est formée par dépôt du matériau conducteur de l'électricité en déposant simultanément l'élément de structure (75) sur la deuxième surface (25) et l'élément d'interconnexion (80) sur le flanc (40), et
dans lequel l'étape de formation de la structure électrique (70) comprend successivement :
- le dépôt d'un premier revêtement de métallisation (90) sur la première surface (12) et sur la deuxième surface (25) ;
- le dépôt d'un deuxième revêtement de métallisation (95) sur le flanc (40) ; et
- le dépôt de la structure électrique (70) par croissance électrolytique simultanément sur le premier revêtement de métallisation (90) et le deuxième revêtement de métallisation (95).

2. Procédé selon la revendication 1, dans lequel le flanc (40) est normal à la première surface (12).

3. Procédé selon l'une quelconque des revendications précédentes, dans lequel le dépôt du deuxième revêtement de métallisation (95) est réalisé par traitement chimique du flanc (40).

4. Procédé selon l'une quelconque des revendications précédentes, dans lequel l'étape de formation de la structure électrique (70) comprend, après les dépôts du premier et deuxième revêtement de métallisation (90, 95), le dépôt d'une couche de résine (100) laissant découvertes les régions du premier revêtement de métallisation (90) destinées à être recouvertes par la structure électrique (70) lors de l'étape de dépôt électrolytique, et le retrait de la couche de résine (100) après le dépôt électrolytique.

5. Procédé selon l'une quelconque des revendications précédentes, lequel est un procédé de fabrication d'un circuit intégré, et dans lequel l'étape de fourniture de l'ensemble comprend l'étape de former au-dessus d'une surface supérieure d'un substrat (5) au moins une couche diélectrique (15) s'étendant sur une surface sous-jacente (12) formant la première surface de l'ensemble, la couche diélectrique (15) présentant une surface supérieure (25) formant la deuxième surface de l'ensemble et un flanc (40) s'étendant entre la surface supérieure (25) de la couche diélectrique (15) et la surface sous-jacente (12).

6. Procédé selon la revendication 5, dans lequel la ou chaque couche diélectrique (15) est en matériau polymère.

7. Procédé selon l'une des revendications 5 et 6, dans lequel le flanc (40) est normal à la surface sous-jacente (12).

8. Procédé selon l'une quelconque des revendications 5 à 7, dans lequel au moins une couche diélectrique (15) est munie d'une ouverture d'interconnexion (30) traversante délimitée par le flanc (40).

9. Procédé selon l'une quelconque des revendications précédentes, dans lequel l'ensemble comprend en outre au moins une surface additionnelle (55) sensiblement parallèle aux première (12) et deuxième surfaces (25), un flanc (40) s'étendant entre la première surface (12) et la deuxième surface (40) et un flanc (60) s'étendant entre la deuxième surface (25) et la surface additionnelle (55), et au moins l'un des flancs (40, 60) présentant une hauteur supérieure à 10µm,
et dans lequel on forme la structure électrique (70) en déposant simultanément un élément de structure (75) s'étendant sur la deuxième surface (25) et un élément de structure (85) s'étendant sur la surface additionnelle (55) et un élément d'interconnexion (80, 86) s'étendant le long des flancs (40, 60) à partir de l'élément de structure (75, 85) s'étendant sur la surface additionnelle (55) et/ou sur la deuxième surface (25) jusqu'à respectivement la deuxième surface (25) ou la première surface (12).

10. Procédé selon la revendication 9, dans lequel chaque flanc (40, 60) présente une hauteur supérieure à 10µm.

11. Procédé selon l'une des revendications 9 et 10, dans laquelle l'étape de dépôt du premier revêtement de métallisation comprend le dépôt du premier revêtement de métallisation (90) sur la surface additionnelle (55) et l'étape de dépôt du deuxième revêtement de métallisation comprend le dépôt du deuxième revêtement de métallisation (95) sur le flanc (60).

12. Procédé selon l'une quelconque des revendications précédentes, dans lequel on forme sur la surface sous-jacente (12) plusieurs couches diélectriques (15, 45) superposées définissant une structure diélectrique en gradin,
chaque couche diélectrique (15, 45) présentant une surface supérieure (25, 55) et un flanc (40, 60) s'étendant entre sa surface supérieure (25, 55) et la surface supérieure (25) d'une couche diélectrique (15) sous-jacente ou la surface sous-jacente (12), au moins l'un des flancs (40, 60) présentant une hauteur supérieure à 10µm,
et dans lequel on forme la structure électrique (70) en déposant simultanément un élément de structure (75, 85) s'étendant sur la surface supérieure (25, 55) de chaque couche diélectrique (15, 45) et un élément d'interconnexion (80, 86) s'étendant le long du flanc (40, 60) de chaque couche diélectrique (15, 45) à partir de l'élément de structure (75, 85) s'étendant sur la surface supérieure (25, 55) de cette couche diélectrique (15, 45) jusqu'à la surface supérieure (25) de la couche diélectrique (15) sous-jacente ou jusqu'à la surface sous-jacente (12).

13. Procédé selon la revendication 12, dans lequel le flanc (40, 60) de chaque couche diélectrique (15, 45) présente une hauteur supérieure à 10µm.

14. Procédé selon l'une des revendications 12 et 13, dans lequel chaque couche diélectrique (15, 45) est en matériau polymère.

15. Procédé selon l'une quelconque des revendications précédentes, dans lequel la structure électrique (70) est formée par dépôt électrolytique.

## Patentansprüche

1. Verfahren zum Herstellen einer Schaltung, das von der Art ist, die die folgenden Schritte umfasst:
- Bereitstellen einer Einheit, die eine erste Fläche (12) und eine zweite Fläche (25), die im Wesentlichen parallel zueinander sind, und eine Flanke (40) hat, die sich zwischen der ersten Fläche (12) und der zweiten Fläche (25) erstreckt,
- Ausbilden einer aus einem Stück bestehenden elektrischen Struktur (70) aus elektrisch leitendem Material, die ein Strukturelement (75), das sich auf der zweiten Fläche (25) erstreckt, und ein Verbindungselement (80) umfasst, das sich ausgehend vom Strukturelement (75) entlang der Flanke (40) bis zur ersten Fläche (12) erstreckt,
wobei die Flanke (40) eine Höhe von über 10 µm aufweist und die elektrische Struktur (70) durch Abscheiden des elektrisch leitenden Materials ausgebildet wird, indem das Strukturelement (75) auf der zweiten Fläche (25) und das Verbindungselement (80) an der Flanke (40) gleichzeitig abgeschieden werden, und
wobei der Schritt des Ausbildens der elektrischen Struktur (70) nacheinander umfasst:
- Abscheiden eines ersten Metallisierungsüberzugs (90) auf der ersten Fläche (12) und der zweiten Fläche (25);
- Abscheiden eines zweiten Metallisierungsüberzugs (95) an der Flanke (40); und
- Abscheiden der elektrischen Struktur (70) durch elektrolytisches Wachstum gleichzeitig auf dem ersten Metallisierungsüberzug (90) und dem zweiten Metallisierungsüberzug (95).

2. Verfahren nach Anspruch 1, wobei die Flanke (40) senkrecht zur ersten Fläche (12) ist.

3. Verfahren nach einem der vorhergehenden Ansprüche, wobei das Abscheiden des zweiten Metallisierungsüberzugs (95) durch chemische Behandlung der Flanke (40) erfolgt.

4. Verfahren nach einem der vorhergehenden Ansprüche, wobei der Schritt des Ausbildens der elektrischen Struktur (70) nach den Abscheidevorgängen des ersten und zweiten Metallisierungsüberzugs (90,95) das Abscheiden einer Harzschicht (100) unter Freilassung der Bereiche des ersten Metallisierungsüberzugs (90), die dazu bestimmt sind, beim Schritt des elektrolytischen Abscheidens mit der elektrischen Struktur (70) bedeckt zu werden, und das Entfernen der Harzschicht (100) nach der elektrolytischen Abscheidung umfasst.

5. Verfahren nach einem der vorhergehenden Ansprüche, das ein Verfahren zur Herstellung einer integrierten Schaltung ist, und wobei der Schritt des Bereitstellens der Einheit den Schritt umfasst, über einer Oberfläche eines Substrats (5) mindestens eine dielektrische Schicht (15) auszubilden, die sich auf einer darunterliegenden Fläche (12) erstreckt, die die erste Fläche der Einheit bildet, wobei die dielektrische Schicht (15) eine Oberfläche (25), die die zweite Fläche der Einheit bildet, und eine Flanke (40) aufweist, die sich zwischen der Oberfläche (25) der dielektrischen Schicht (15) und der darunterliegenden Fläche (12) erstreckt.

6. Verfahren nach Anspruch 5, wobei die oder jede dielektrische Schicht (15) aus einem Polymermaterial ist.

7. Verfahren nach einem der Ansprüche 5 und 6, wobei die Flanke (40) zur darunterliegenden Fläche (12) senkrecht ist.

8. Verfahren nach einem der Ansprüche 5 bis 7, wobei mindestens eine dielektrische Schicht (15) mit einer durchführenden Verbindungsöffnung (30) versehen ist, die durch die Flanke (40) begrenzt ist.

9. Verfahren nach einem der vorhergehenden Ansprüche, wobei die Einheit darüber hinaus mindestens eine zusätzliche Fläche (55) hat, die im Wesentlichen parallel zur ersten (12) und zweiten Fläche (25) ist, wobei sich eine Flanke (40) zwischen der ersten Fläche (12) und der zweiten Fläche (40) erstreckt, und sich eine Flanke (60) zwischen der zweiten Fläche (25) und der zusätzlichen Fläche (55) erstreckt, und zumindest eine der Flanken (40, 60) eine Höhe von über 10 µm aufweist,
und wobei die elektrische Struktur (70) ausgebildet wird, indem gleichzeitig ein Strukturelement (75), das sich auf der ersten Fläche (25) erstreckt, und ein Strukturelement (85), das sich auf der zusätzlichen Fläche (55) erstreckt, und ein Verbindungselement (80, 86) abgeschieden werden, das sich entlang der Flanken (40, 60) ausgehend vom Strukturelement (75, 85) erstreckt, das sich auf der zusätzlichen Fläche (55) und/oder auf der zweiten Fläche (25) bis zur zweiten Fläche (25) bzw. zur ersten Fläche (12) erstreckt.

10. Verfahren nach Anspruch 9, wobei jede Flanke (40, 60) eine Höhe von über 10 µm aufweist.

11. Verfahren nach einem der Ansprüche 9 und 10, wobei der Schritt des Abscheidens des ersten Metallisierungsüberzugs das Abscheiden des ersten Metallisierungsüberzugs (90) auf der zusätzlichen Fläche (55) umfasst, und der Schritt des Abscheidens des zweiten Metallisierungsüberzugs das Abscheiden des zweiten Metallisierungsüberzugs (95) an der Flanke (60) umfasst.

12. Verfahren nach einem der vorhergehenden Ansprüche, wobei auf der darunterliegenden Fläche (12) mehrere übereinanderliegende dielektrische Schichten (15, 45) ausgebildet werden, die eine stufenförmige dielektrische Struktur bilden,
wobei jede dielektrische Schicht (15, 45) eine Oberfläche (25, 55) und eine Flanke (40, 60) aufweist, die sich zwischen ihrer Oberfläche (25, 55) und der Oberfläche (25) einer darunterliegenden dielektrischen Schicht (15) oder der darunterliegenden Fläche (12) erstreckt, wobei zumindest eine der Flanken (40, 60) eine Höhe von über 10 µm aufweist,
und wobei die elektrische Struktur (70) ausgebildet wird, indem gleichzeitig ein Strukturelement (75, 85), das sich auf der Oberfläche (25, 55) jeder dielektrischen Schicht (15, 55) erstreckt, und ein Verbindungselement (80, 86) abgeschieden werden, das sich entlang der Flanke (40, 60) jeder dielektrischen Schicht (15, 45) ausgehend von Strukturelement (75, 85) erstreckt, das sich auf der Oberfläche (25, 55) dieser dielektrischen Schicht (15, 45) bis zur Oberfläche (25) der darunterliegenden dielektrischen Schicht (15) oder bis zur darunterliegenden Fläche (12) erstreckt.

13. Verfahren nach Anspruch 12, wobei die Flanke (40, 60) jeder dielektrischen Schicht (15, 45) eine Höhe von über 10 µm aufweist.

14. Verfahren nach einem der Ansprüche 12 und 13, wobei jede dielektrische Schicht (15, 45) aus einem Polymermaterial ist.

15. Verfahren nach einem der vorhergehenden Ansprüche, wobei die elektrische Struktur (70) durch elektrolytisches Abscheiden ausgebildet wird.

## Claims

1. A method for manufacturing a circuit, of the type comprising the steps of:
- providing an assembly comprising a first surface (12) and a second surface (25) substantially parallel with each other and a flank (40) extending between the first surface (12) and the second surface (25),
- forming an electrical structure (70) made in one piece in an electrically conducting material, comprising a structural element (75) extending on the second surface (25) and an interconnection element (80) extending from the structural element (75) along the flank (40) as far as the first surface (12),
wherein the flank (40) has a height of more than 10µm, and the electrical structure (70) is formed by depositing the electrically conducting material by simultaneously depositing the structural element (75) on the second surface (25) and the interconnection element (80) on the flank (40), and
wherein the step of forming the electrical structure (70) successively comprises:
- the deposition of a first metallization coating (90) on the first surface (12) and on the second surface (25);
- the deposition of a second metallization coating (95) on the flank (40); and
- the deposition of the electrical structure (70) by electrolytic growth, simultaneously on the first metallization coating (90) and the second metallization coating (95).

2. The method according to claim 1, wherein the flank (40) is normal to the first surface (12).

3. The method according to any one of the preceding claims, wherein the deposition of the second metallization coating (95) is achieved by chemical treatment of the flank (40).

4. The method according to any one of the preceding claims, wherein the step of forming the electrical structure (70) comprises, after the depositions of the first and second metallization coatings (90, 95), the deposition of a resin layer (100) leaving exposed the regions of the first metallization coating (90) intended to be covered with the electrical structure (70) during the electrolytic deposition step, and the removal of the resin layer (100) after the electrolytic deposition.

5. The method according to any of the preceding claims, which is a method for manufacturing an integrated circuit, and wherein the step of providing the assembly comprises the step of forming above an upper surface of a substrate (5), at least one dielectric layer (15) extending on an underlying surface (12) forming the first surface of the assembly, the dielectric layer (15) having an upper surface (25) forming the second surface of the assembly and a flank (40) extending between the upper surface (25) of the dielectric layer (15) and the underlying surface (12).

6. The method according to claim 5, wherein the or each dielectric layer (15) is in polymeric material.

7. The method according to one of claims 5 and 6, wherein the flank (40) is undercut relatively to the underlying surface (12) or normal to the underlying surface (12).

8. The method according to any of claims 5 to 7, wherein at least one dielectric layer (15) is provided with an interconnection through-aperture (30) delimited by the flank (40).

9. The method according to any of the preceding claims, wherein the assembly further comprises at least one additional surface (55) substantially parallel to the first (12) and second surfaces (25), a flank (40) extending between the first surface (12) and the second surface (40) and a flank (60) extending between the second surface (25) and the additional surface (55), and at least one of the flanks (40, 60) having a height of more than 10 µm,
and wherein the electrical structure (70) is formed by simultaneously depositing a structural element (75) extending on the second surface (25) and a structural element (85) extending on the additional surface (55) and an interconnection element (80, 86) extending along the flanks (40, 60) from the structural element (75, 85) extending on the additional surface (55) and/or on the second surface (25) as far as the second surface (25) or the first surface (12), respectively.

10. The method according to claim 9, wherein each flank (40, 60) has a height of more than 10 µm.

11. The method according to one of claims 9 and 10, wherein the step of depositing the first metallization coating comprises the deposition of the first metallization coating (90) on the additional surface (55) and the step of depositing the second metallization coating comprises the deposition of the second metallization coating (95) on the flank (60).

12. The method according to any of the preceding claims, wherein several superposed dielectric layers (15, 45) defining a stepped dielectric structure are formed on the underlying surface (12),
each dielectric layer (15, 45) having an upper surface (25, 55) and a flank (40,60) extending between its upper face (25, 55) and the upper surface (25) of an underlying dielectric layer (15) or the underlying surface (12), at least one of the flanks (40, 60) having a height of more than 10 µm,
and wherein the electrical structure (70) is formed by simultaneously depositing a structural element (75, 85) extending on the upper surface (25, 55) of each dielectric layer (15, 45) and an interconnection element (80, 86) extending along the flank (40, 60) of each dielectric layer (15, 45) from the structural element (75, 85) extending on the upper surface (25, 55) of this dielectric layer (15, 45) as far as the upper surface (25) of the underlying dielectric layer (15) or as far as the underlying surface (12).

13. The method according to claim 12, wherein the flank (40, 60) of each dielectric layer (15, 45) has a height of more than 10 µm.

14. The method according to one of claims 12 and 13, wherein each dielectric layer (15, 45) is in polymeric material.

15. The method according to any of the preceding claims, wherein the electrical structure (70) is formed by electrolytic deposition.
